## Europäisches Patentamt

## European Patent Office

## Office européen des brevets

(19)

(11) Veröffentlichungsnummer: **0 030 056**
**B1**

(12) **EUROPÄISCHE PATENTSCHRIFT**

(45) Veröffentlichungstag der Patentschrift:
13.04.83

(51) Int. Cl.³: **G 03 G 15/00**, G 01 R 29/24,
H 04 N 1/028

(21) Anmeldenummer: 80201109.8

(22) Anmeldetag: **24.11.80**

(54) Influenzsondenanordnung und Verfahren zu ihrer Herstellung.

(30) Priorität: **04.12.79 DE 2948660**

(43) Veröffentlichungstag der Anmeldung:
10.06.81 Patentblatt 81/23

(45) Bekanntmachung des Hinweises auf die Patenterteilung:
13.04.83 Patentblatt 83/15

(84) Benannte Vertragsstaaten:
**CH DE FR GB IT LI**

(56) Entgegenhaltungen:
**US-A-4 134 137**
**JOURNAL OF PHYSICS E: SCIENTIFIC INSTRU-**
**MENTS, Band 6, 1973 B. SCRUTON et al. »A High**
**Resolution Probe for Scanning Electrostatic Po-**
**tential Profiles across Surfaces« Seiten 472 bis 474**
**JOURNAL OF PHYSICS E: SCIENTIFIC INSTRU-**
**MENTS, Band 4, 1971 K. A. HIGHES et al. »A**
**Two-Dimensional Charge Scanning Instrument**
**for Flat Insulating Sheet« Seiten 362 bis 365**

(73) Patentinhaber: **Philips Patentverwaltung GmbH,**
**Steindamm 94, D-2000 Hamburg 1 (DE)**

(84) Benannte Vertragsstaaten: **DE**

(73) Patentinhaber: **N.V. Philips' Gloeilampenfabrieken,**
**Groenewoudseweg 1, NL-5621 BA Eindhoven (NL)**

(84) Benannte Vertragsstaaten: **CH FR GB IT LI**

(72) Erfinder: **Schiebel, Ulrich Dr., Zehntweg 60,**
**D-5100 Aachen-Brand (DE)**
Erfinder: **Wädow, Dieter, Knipp 15, D-5100 Aachen-Hahn**
**(DE)**

(74) Vertreter: Hartmann, Heinrich, Dipl.-Ing. et al, Philips
Patentverwaltung GmbH Steindamm 94,
D-2000 Hamburg 1 (DE)

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

BUNDESDRUCKEREI BERLIN

## Influenzsondenanordnung und Verfahren zu ihrer Herstellung

Die Erfindung bezieht sich auf eine Influenzsondenanordnung zur Erfassung der Ladungsverteilung auf einer elektrisch aufgeladenen Oberfläche, mit einer Influenzsonde, die eine Sondenelektrode enthält und eine geerdete Abschirmelektrode, die den Teil der Sondenelektrode, auf dem Ladung influenziert werden soll — den Sondenelektrodenkopf — definiert, und ein Verfahren zur Herstellung einer solchen Influenzsondenanordnung.

In der Elektrofotografie bzw. in der Elektroradiografie entstehen zunächst elektrostatische (latente) Ladungsbilder, die üblicherweise mit Hilfe von elektrisch geladenen Pigmentteilchen (Tonern) sichtbar gemacht werden.

Alternativ ist es auch möglich, die Ladungsbilder mit Hilfe von Influenzsonden elektronisch auszulesen und so z. B. der Bildverarbeitung in einem Rechner zugänglich zu machen, was von besonderem Vorteil ist, wenn Bilder quantitativ ausgewertet werden sollen.

In diesem Fall müssen die Bildträger, auf denen sich die Ladungsverteilung befindet (z. B. Selenplatten oder dergleichen) mit Influenzsonden abgetastet werden, deren für die Messung wirksame Oberfläche, auf der Ladungen influenziert werden, der sogenannte Sondenelektrodenkopf, sehr klein ist (z. B. $100 \times 100 \ \mu m^2$). In der Zeitschrift »Journal of Physics E« Vol. 4, 1971, Seiten 362 bis 365 sowie Vol. 6, 1973, Seiten 472 bis 474 sind Influenzsondenausführungen beschrieben, die eine entsprechend kleine Sondenelektrodenkopffläche aufweisen. Die Anzahl der Bildpunkte, die bei einer Elektrofotografie bzw. -radiografie abgetastet werden müßte, wäre sehr groß $10^6$ bis $10^7$), und daher wäre eine rationelle Abtastung nur möglich, wenn eine Vielzahl solcher Sonden verwendet würde.

Bei den bekannten Influenzsondenanordnungen besteht die Sondenelektrode aus einem Draht, der senkrecht zu der abzutastenden Oberfläche gerichtet ist und der durch eine Isolierschicht getrennt von einem konzentrischen Kragen umschlossen wird, der als Abschirmelektrode dient. Eine solche Abschirmelektrode ist stets erforderlich, um ein gutes räumliches Auflösungsvermögen bei der Abtastung einer Ladungsverteilung zu erzielen.

Die Serienfertigung einer Influenzsondenanordnung mit einer Vielzahl derartiger koaxialer Sondenelektroden dürfte erhebliche Schwierigkeiten bereiten und teuer sein. Insbesondere dürften sich Schwierigkeiten bei der Isolation zwischen der Sondenelektrode und dem Abschirmring ergeben. Es wäre auch kaum möglich, in einer Geraden eine Vielzahl solcher Influenzsonden in dichter Packung anzuordnen, weil die Abschirmelektroden eine solche dichte Packung ausschließen. Erhebliche Probleme würde es auch bereiten, die einzelnen Influenzsonden so anzuordnen, daß die Sondenelektrodenköpfe jeweils den gleichen Abstand von der abzutastenden Oberfläche haben. Die bekannten Influenzsonden sind daher nicht zum Einsatz in eine Influenzsondenanordnung mit einer Vielzahl von Influenzsonden geeignet.

Aufgabe der vorliegenden Erfindung ist es daher, eine Influenzsondenanordnung mit einer Vielzahl von Influenzsonden zu schaffen. Diese Aufgabe wird ausgehend von einer Influenzsondenanordnung der eingangs genannten Art dadurch gelöst, daß auf einem elektrisch isolierenden Substrat eine Vielzahl von nebeneinander angeordneten gegeneinander isolierten Elektrodenbahnen aufgebracht ist, die als Sondenelektroden dienen, daß sich auf den Elektrodenbahnen — zumindest im Bereich der Sondenelektrodenköpfe — eine zusammenhängende Isolierschicht befindet, und daß auf der Isolierschicht, eine elektrisch leitende Deckschicht angebracht ist, die für jede Sondenelektrode im Bereich ihres Sondenelektrodenkopfes eine Öffnung aufweist. Die auf der Isolierschicht angebrachte elektrisch leitende Schicht mit den darin vorgesehenen Öffnungen hat dabei für alle Sondenelektroden die Funktion einer Abschirmelektrode. Diese Schicht wird im Betriebszustand geerdet.

Bei der erfindungsgemäßen Influenzsondenanordnung ist also der koaxiale Aufbau der Influenzsonden durch einen mehrschichtig planaren ersetzt. Die Herstellung ist sehr einfach, weil lediglich einige Schichten (Elektrodenbahn, Isolierschicht und leitende Schicht) auf ein Substrat aufgebracht werden müssen, um eine Vielzahl von Influenzsonden herzustellen.

Der Teil des Substrates, auf dem die Sondenelektrodenköpfe angeordnet sind, muß genügend eben sein, um für alle Elektrodenköpfe einen gleichen Abstand zur abzutastenden Oberfläche zu gewährleisten. Werden die Elektrodenköpfe in einer (oder zwei) linearen Reihe(n) angeordnet, so ist diese Forderung auch dann zu erfüllen, wenn man ein zylinderlinsenförmiges Substrat verwendet und die Reihe der Elektrodenköpfe in Richtung der Zylinderachse anordnet.

Bei der Erfindung ergeben sich keinerlei Isolationsprobleme, wenn die Isolierschicht genügend dick ist und ein geeigneter Isolator verwendet wird, z. B. Siliziumoxid ($SiO_2$).

Der Zwischenraum zwischen zwei Sondenelektrodenköpfen muß dabei gerade so groß sein, daß die dazwischen fließenden Leckströme vernachlässigt werden können; es ist daher eine verhältnismäßig dichte Packung (in einer Richtung) der Influenzsonden möglich.

Der Zwischenraum zwischen zwei Sondenelektrodenköpfen kann naturgemäß nicht zu Null werden. Infolgedessen würden, wenn die Sondenelektrodenköpfe in einer einzigen Reihe angeordnet wären (wenn also die Verbindungslinie ihrer Mittelpunkte eine Gerade wäre) und wenn die Influenzsondenanordnung parallel zur abzutastenden Oberfläche und senkrecht zu dieser Reihe verschoben werden würde, auf der abzutastenden Oberfläche Streifen verbleiben, deren Ladung nicht erfaßt würde. Diesen Nachteil vermeidet eine Weiterbildung der Erfindung dadurch, daß zwei Gruppen von Sondenelektroden vorgesehen sind, daß die Sondenelektrodenköpfe beider Gruppen auf je einer Geraden liegen, die parallel und in geringem Abstand voneinander verlaufen, und daß der übrige Teil der Sondenelektroden sich auf jeweils einer der voneinander abgewandten Seiten der Geraden erstrecken, wobei die Sondenelektrode einer Gruppe in Richtung der Geraden voneinander jeweils einen mittigen Abstand haben, der der doppelten Abmessung einer Öffnung in dieser Richtung entspricht, und daß die Sondenelektroden der beiden Gruppen in dieser Richtung um die Abmessung einer Öffnung gegeneinander versetzt sind.

Eine andere Weiterbildung der Erfindung sieht vor, daß das Substrat eine ebene Fläche aufweist, auf der sich die Sondenelektrodenköpfe befinden, und daß diese Fläche von zwei ebenen abgewinkelten Seitenflächen begrenzt wird, die sich in einer Geraden außerhalb des Substrates schneiden. Durch diese Ausbildung wird erreicht, daß bei der Abtastung der Ladungsverteilung auf einer ebenen Oberfläche die Fläche mit den Sondenelektrodenköpfen am dichtesten an diese Fläche herangebracht werden kann, während die auf den abgewinkelten Seitenflächen angeordneten Teile der Sondenelektroden einen größeren Abstand von der abzutastenden Oberfläche haben. Sie können daher die abzutastende Ladungsverteilung nicht störend beeinflussen, und es können auf den Seitenflächen zusätzliche Komponenten, z. B. hochohmige Vorverstärker, angebracht werden.

Die Influenzsondenanordnung kann nach der Erfindung besonders einfach dadurch hergestellt werden, daß zunächst auf das Substrat eine erste leitende Schicht aufgebracht wird, aus der anschließend die Elektrodenbahnen herausgeätzt werden, daß danach auf die durch Ätzen bearbeitete erste leitende Schicht eine Isolierschicht aufgebracht wird, auf die danach eine zweite leitende Schicht aufgebracht wird, in die die Öffnungen eingeätzt werden.

Die Influenzsondenanordnung kann alternativ besonders einfach dadurch hergestellt werden, daß eine dünne, flexible, elektrisch isolierende Folie (z. B. 25 μm dickes Polyimid) beidseitig metallisiert wird, daß auf der einen Seite die Elektrodenbahnen aus der Metallschicht herausgeätzt werden, daß auf der anderen Seite die die Sondenelektrodenköpfe definierenden Öffnungen in die Metallschicht eingeätzt werden, und daß die so bearbeitete Folie auf ein elektrisch isolierendes Substrat geeigneter Form aufgespannt bzw. aufgeklebt wird.

Die Erfindung wird nachstehend anhand eines in der Zeichnung dargestellten Ausführungsbeispiels näher erläutert. Es zeigt

Fig. 1 einen Querschnitt durch eine Influenzsondenanordnung und

Fig. 2a bis Fig. 2c eine Draufsicht auf einen Teil der Influenzsondenanordnung in verschiedenen Stufen des Herstellungsprozesses.

Die Influenzsondenanordnung ist nicht maßstabsgetreu dargestellt, damit die wesentlichen Merkmale der Erfindung deutlicher hervortreten können.

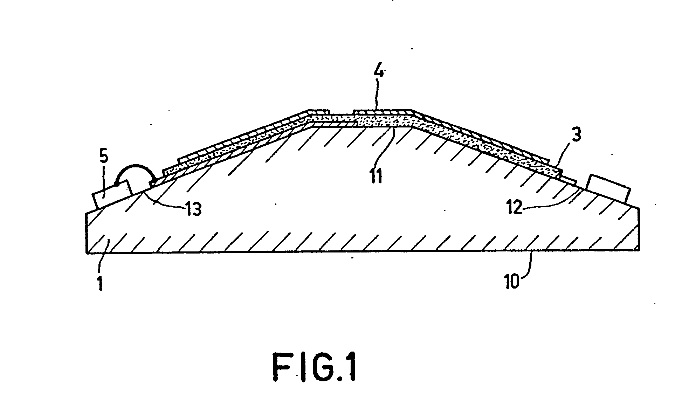

In Fig. 1 ist mit 1 ein aus Quarzglas bestehendes Substrat bezeichnet, das eine ebene, Grundfläche 10 von 20 mm Breite (das sind die Abmessungen in horizontaler Richtung) und auf seiner Oberseite im Zentrum eine dazu parallele ebene Fläche 11 mit einer Breite von ca. 2 mm aufweist. An die Fläche 11 schließen sich seitlich zwei abgewinkelte Seitenflächen 12 und 13 an, die unter einem Winkel von z. B. 20° bzw. 160° gegenüber der Fläche 11 geneigt sind und die sich in einer Geraden oberhalb der Fläche 11 schneiden.

Das Substrat muß nicht unbedingt aus Quarzglas bestehen. Wesentlich ist nur, daß seine Oberfläche eine sehr geringe elektrische Leitfähigkeit hat und daß es eine genügende Temperaturbeständigkeit hat, um das Aufbringen der verschiedenen Schichten unverändert zu überstehen.

Das Substrat hat über seine gesamte Länge von z. B. 50 mm — d. h. in Richtung senkrecht zur Zeichenebene — den in Fig. 1 dargestellten Querschnitt.

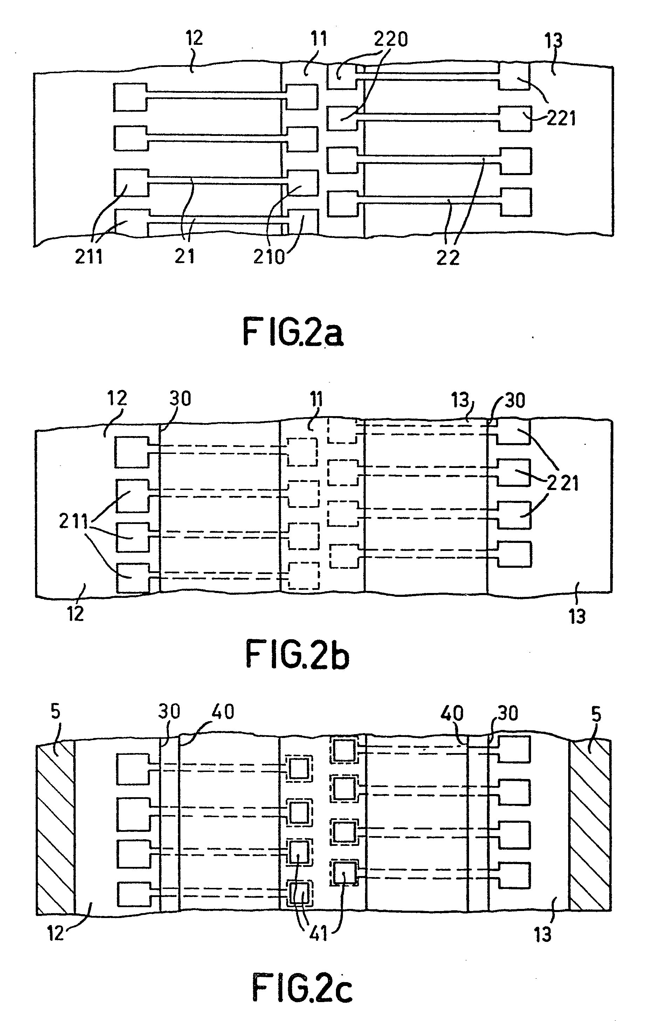

In einem ersten Schritt wird auf das Substrat 1 eine 100 nm dicke elektrisch leitende Schicht aus z. B. Aluminium aufgebracht. Das Aufbringen erfolgt mittels Kathodenzerstäubung (Sputtern), könnte aber grundsätzlich auch durch Aufdampfen erfolgen. Anschließend werden aus der so gebildeten auf den Flächen 11, 12 und 13 befindlichen Schicht unter Verwendung einer ebenen, jedoch die Neigung der Seitenflächen berücksichtigenden Fotomaske durch übliche fotolithografische Verfahren die Sondenelektroden herausgeätzt, wobei sich die in Fig. 2a dargestellte Anordnung ergibt.

Fig. 2a zeigt zwei Gruppen von Sondenelektroden 21 bzw. 22. Die Sondenelektroden 21 besitzen auf der ebenen Fläche 11 angeordnete Elektrodenköpfe 210, deren Abmessungen etwa $100 \times 100 \ \mu m^2$ betragen. Verbindet man die Mittelpunkte dieser Elektrodenköpfe, ergibt sich eine Gerade, die links von der Mitte der ebenen Fläche 11 liegt. Die Gruppe der Sondenelektroden erstreckt sich zur linken Seitenfläche 12 hin und besitzt an ihren Enden Bondflächen 211 zum elektrischen Anschluß der Sondenelektroden. Die Sondenelektroden 21 erstrecken sich ungefähr senkrecht zur Verbindungsgeraden der Sondenelektrodenköpfe und ihre Symmetrielinien haben voneinander einen Abstand, der etwa dem doppelten der Abmessung eines Sondenelektrodenkopfes in Längsrichtung entspricht. Die andere Gruppe von Sondenelektroden 22 besitzt ebenfalls auf der ebenen Fläche 11 angebrachte Elektrodenköpfe 220, jedoch liegen die Mittelpunkte der Sondenelektrodenköpfe auf einer Geraden, die etwas weiter rechts liegt als die Verbindungsgerade der Sondenlektrodenköpfe 210 und parallel zu dieser verläuft. Die Sondenelektroden 22 erstrecken sich zur rechten Seite hin und verlaufen also im wesentlichen auf der rechten Seitenfläche 13, wo sich auch ihre Bondflächen 221 befinden. Die Gruppe der Sondenelektroden 22 ist gegenüber der Gruppe der Sondenelektroden 21 in Längsrichtung (in Fig. 2a also in vertikaler Richtung) um die Hälfte des Abstandes zweier Sondenelektroden einer Gruppe versetzt. Im übrigen sind beide Sondenelektrodengruppen identisch aufgebaut.

In einem zweiten Schritt wird auf die Seitenflächen 11, 12, 13 eine Isolierschicht 3 aus Siliziumdioxid ($SiO_2$), deren Ränder in Fig. 2b mit 30 bezeichnet sind und die gerade noch die Bondflächen 211 bzw. 221 der darunter befindlichen Sondenelektroden freiläßt, aufgebracht. Die etwa 1 μm dicke Siliziumdioxidschicht kann wiederum durch Kathodenzerstäubung (Sputtern) aufgebracht werden. Je dicker diese Schicht ist, um so besser ist die Isolation zwischen der Sondenelektrode und Abschirmelektrode und um so geringer wird die Kapazität zwischen diesen beiden Elektroden.

In einem dritten Herstellungsschritt wird auf die Isolierschicht 3 eine elektrisch leitende Deckschicht, z. B. aus Aluminium, aufgebracht. Das Aufbringen kann wiederum durch Kathodenzerstäubung (Sputtern) erfolgen. Diese Deckschicht, deren Rand in Fig. 2c mit 40 bezeichnet ist, läßt den Bereich an den Rändern 30 der Isolierschicht 3 frei, so daß sich zwischen der Deckschicht und den Bondflächen eine hinreichende Isolationsstrecke befindet. Anschließend werden in die z. B. 200 nm dicke Deckschicht jeweils in dem über den Sondenelektrodenköpfen befindlichen Bereich in einem weiteren fotolithografischen Arbeitsgang Öffnungen 41 hineingeätzt, deren Größe der Größe der Sondenelektrodenköpfe entspricht und diese somit definiert.

Auf den Seitenflächen 12 und 13 können vorzugsweise in integrierter Schaltungstechnik ausgeführte hochohmige Verstärkerstufen angeordnet sein, wobei für jeweils eine Sondenelektrode eine Verstärkerstufe vorgesehen ist, deren Eingangselektrode an eine der Bondflächen 221 bzw. 211 angeschlossen ist und deren zweiter Eingang im Betriebszustand dasselbe Potential führt wie die leitende Deckschicht, also geerdet ist. Diese Verstärkerstufen sind in Fig. 1 schematisch dargestellt und mit 5 bezeichnet.

Zum Abtasten einer ebenen Oberfläche wird die Fläche 11 in einem Abstand von z. B. 50 μm von der abzutastenden Oberfläche positioniert, wobei durch die Öffnungen 41 in der Deckschicht 4 hindurch auf den Sondenelektroden Ladungsträger influenziert werden, wodurch am Eingang der angeschlossenen Verstärkerstufe eine Spannung erzeugt wird, die der Zahl der influenzierten Ladungsträger und damit der Ladung in dem gegenüber befindlichen Bereich der aufgeladenen Oberfläche proportional ist. Ist auf diese Weise die Ladungsverteilung längs einer Zeile, die durch die Verbindungsgeraden der Elektrodenköpfe 210 bzw. 220 definiert ist, erfaßt, dann kann die Influenzsondenanordnung senkrecht zur Zeilenrichtung verschoben werden, um die Ladungsverteilung auf einem neuen Abschnitt zu erfassen.

Neben den schon erwähnten Vorteilen (hohe Ortsauflösung, rationelle Fertigung usw.) hat die erfindungsgemäße Influenzsondenanordnung noch folgende Vorteile:

Zwischen einer Sondenelektrode und der Deckschicht, die ja als Abschirmelektrode fungiert, ergeben sich kleine Kapazitäten ($\leq 4$ pF). Zwischen zwei benachbarten Sondenelektroden ergeben sich extrem kleine Kapazitäten; das dadurch hervorgerufene Übersprechen kann kleiner als 2% gehalten werden. — Eine eindimensional dichte Packung von Sondenelektroden ist möglich. Die Sondenelektrodenköpfe befinden sich exakt in einer Ebene, so daß die Abstandsjustierung bezüglich der ebenen Oberfläche, deren Ladungsverteilung zu ermitteln ist, simultan für alle Sondenelektroden auf einem Substrat erfolgen kann.

**Patentansprüche**

1. Influenzsondenanordnung zur Erfassung der Ladungsverteilung auf einer elektrisch aufgeladenen Oberfläche, mit einer Influenzsonde, die eine Sondenelektrode enthält und eine geerdete Abschirmelektrode, die den Teil der Sondenelektrode, auf dem Ladung influenziert werden soll — den Sondenelektrodenkopf — definiert, dadurch gekennzeichnet, daß auf einem elektrisch isolierenden Substrat (1) eine Vielzahl von nebeneinander angeordneten gegeneinander isolierten Elektrodenbahnen (21, 22) aufgebracht ist, die als Sondenelektroden dienen, daß sich auf den Elektrodenbahnen — zumindest im Bereich der Sondenelektrodenköpfe (210, 220) — eine zusammenhängende Isolierschicht (3) befindet, und daß auf der Isolierschicht (3) eine elektrisch leitende Deckschicht (4) angebracht ist, die für jede Sondenelektrode (21, 22) im Bereich ihres Sondenelektrodenkopfes (210, 220) eine Öffnung (41) aufweist.

2. Influenzsondenanordnung nach Anspruch 1, dadurch gekennzeichnet, daß die Sondenelektrodenköpfe (210 bzw. 220) so auf dem Substrat (1) angeordnet sind, daß ihre Verbindungslinie eine Gerade darstellt.

3. Influenzsondenanordnung nach Anspruch 2, dadurch gekennzeichnet, daß die Sondenelektroden (21, 22) parallel zueinander verlaufen und etwa senkrecht zu der Verbindungsgeraden der Sondenelektrodenköpfe (210 bzw. 220).

4. Influenzsondenanordnung nach einem der vorhergehenden Ansprüche, dadurch gekennzeichnet, daß zwei Gruppen von Sondenelektroden (21 bzw. 22) vorgesehen sind, daß die Sondenelektrodenköpfe (210 bzw. 220) beider Gruppen auf je einer Geraden liegen, die parallel und in geringem Abstand voneinander verlaufen, und daß der übrige Teil der Sondenelektroden (21 bzw. 22) sich auf jeweils einer der voneinander abgewandten Seiten der Geraden erstreckt, wobei die Sondenelektroden einer Gruppe in Richtung der Geraden voneinander jeweils einen mittigen Abstand haben, der etwa der doppelten Abmessung einer Öffnung (41) in dieser Richtung entspricht, und daß die Sondenelektroden der beiden Gruppen in dieser Richtung um die Abmessung einer Öffnung (41) gegeneinander versetzt sind.

5. Influenzsondenanordnung nach einem der vorhergehenden Ansprüche, dadurch gekennzeichnet, daß das Substrat (1) eine ebene Fläche (11) aufweist, auf der sich die Sondenelektrodenköpfe (210, 220) befinden, und daß diese Fläche von zwei ebenen abgewinkelten Seitenflächen (12, 13) begrenzt wird, die sich in einer Geraden außerhalb des Substrates schneiden.

6. Influenzsondenanordnung nach einem der Ansprüche 1 bis 4, dadurch gekennzeichnet, daß das Substrat (1) zylinderlinsenförmig ausgebildet ist (aus einem Zylinderabschnitt besteht) und daß die Sondenelektrodenköpfe (210 bzw. 220) in einer oder zwei Reihen in Richtung der Zylinderachse angeordnet sind.

7. Influenzsondenanordnung nach einem der vorhergehenden Ansprüche, dadurch gekennzeichnet, daß das Substrat (1) aus Quarzglas besteht.

8. Influenzsondenanordnung nach einem der vorhergehenden Ansprüche, dadurch gekennzeichnet, daß die Isolierschicht (3) aus $SiO_2$ besteht.

9. Verfahren zur Herstellung einer Influenzsondenanordnung nach Anspruch 1, dadurch gekennzeichnet, daß zunächst auf das Substrat (1) eine erste leitende Schicht aufgebracht wird, aus der anschließend die Elektrodenbahnen (21, 22) herausgeätzt werden, daß danach auf die durch Ätzen bearbeitete erste leitende Schicht eine Isolierschicht (3) aufgebracht wird, auf die danach eine zweite leitende Schicht (4) aufgebracht wird, in die die Öffnungen (41) eingeätzt werden.

10. Verfahren zur Herstellung einer Influenzsondenanordnung nach Anspruch 1, dadurch gekennzeichnet, daß eine dünne, flexible, elektrisch isolierende Folie zunächst beidseitig metallisiert wird, daß auf der einen Seite die Elektrodenbahnen (21, 22) herausgeätzt werden, daß auf der anderen Seite die die Sondenelektrodenköpfe (210, 220) definierenden Öffnungen (41) eingeätzt werden, und daß die so bearbeitete Folie auf ein geeignet geformtes, elektrisch isolierendes Substrat (1) aufgespannt bzw. aufgeklebt wird.

## Claims

1. An influence probing arrangement for determining the charge distribution on an electrically charged surface, comprising an influence probe which comprises a probe electrode and a grounded screening electrode, which defines the part of the probe electrode on which charge is to be influenced — the probe electrode head — characterized in that on an electrically insulating substrate (1) there are provided a large number of adjacently arranged, mutually insulated electrode tracks (21, 22) which serve as probe electrodes, on the electrode tracks there being provided, at least at the area of the probe electrode heads (210, 220), a coherent insulating layer (3), on the insulating layer (3) there being provided an electrically conductive cover layer (4) which comprises an opening (41) for each probe electrode (21, 22) at the area of its probe electrode head (210, 220).

2. An influence probing arrangement as claimed in Claim 1, characterized in that the probe electrode heads (210, 220) are arranged on the substrate (1) so that their connecting line forms a straight line.

3. An influence probing arrangement as claimed in Claim 2, characterized in that the probe electrodes (21, 22) extend parallel to each other and approximately perpendicularly to the straight connecting line of the probe electrode heads (210, 220).

4. An influence probing arrangement as claimed in one of the preceding Claims, characterized in that there are provided two groups of probe electrodes (21, 22), the probe electrode heads (210, 220) of each group being situated on a straight line, said lines extending in parallel and at a short distance from each other, the remaining part of the probe electrodes (21, 22) extending each time on one of the remote sides of the straight line, the centre-to-centre distance of the probe electrodes of a group in the direction of the straight line being approximately equal to twice the dimension of an opening (41) in this direction, the probe electrodes of both groups being shifted in this direction over a distance which corresponds to the dimension of an opening (41) with respect to each other.

5. An influence probing arrangement as claimed in one of the preceding Claims, characterized in that the substrate (1) comprises a flat surface (11) on which the probe electrode heads (210, 220) are provided, this surface being bounded by two flat, slanted side surfaces (12, 13) which intersect each other in a straight line outside the substrate.

6. An influence probing arrangement as claimed in one of the Claims 1 to 4, characterized in that the substrate (1) has a cylindrical lens shape (consists of a cylinder section), the probe electrode heads (210, 220) being arranged in one or two rows in the direction of the cylinder axis.

7. An influence probing arrangement as claimed in any of the preceding Claims, characterized in that the substrate (1) is made of quartz glass.

8. An influence probing arrangement as claimed in any of the preceding Claims, characterized in that the insulating layer (31) is made of SiO₂.

9. A method of manufacturing an influence probing arrangement as claimed in Claim 1, characterized in that on the substrate (1) first a first conductive layer is deposited, the electrode tracks (21, 22) being subsequently formed therein by etching, after which an insulating layer (3) is deposited on the etched first conductive layer, after which thereon a second conductive layer (4) is provided in which the openings (41) are formed by etching.

10. A method of manufacturing an influence probing arrangement as claimed in Claim 1, characterized in that a thin, flexible, electrically insulating foil is first metallized on both sides, the electrode tracks (21, 22) being formed on the one side by etching, the openings (41) which define the probe electrode heads (210, 220) being etched on the other side, the foil thus treated being stretched or glued onto a suitable shaped, electrically insulating substrate (1).

**Revendications**

1. Dispositif de sonde à influence destiné à détecter la répartition des charges sur une surface chargée électriquement comportant une sonde à influence qui comporte une électrode sonde et une électrode de blindage mise à la masse qui définit la partie de l'électrode sonde sur laquelle des charges doivent être induites par influence (la tête d'électrode de sonde), caractérisé en ce que de nombreuses pistes électrodes (21, 22) isolées les unes des autres sont disposées les unes à côté des autres sur un substrat électriquement isolant (1) et servent d'électrodes sondes, une couche isolante cohérente (3) est prévue sur les pistes électrodes [au moins dans la zone des têtes d'électrodes sondes (210, 220)], et une couche de recouvrement conductrice électrique (4) est appliquée sur la couche isolante (3) et présente une ouverture (41) pour chaque électrode sonde (21, 22) dans la zone de sa tête d'électrode sonde (210, 220).

2. Dispositif de sonde à influence suivant la revendication 1, caractérisé en ce que les têtes d'électrodes sondes (210, 220) sont disposées sur le substrat (1) de telle sorte que la ligne qui les relie soit une ligne droite.

3. Dispositif de sonde à influence suivant la revendication 2, caractérisé en ce que les électrodes sondes (21, 22) sont parallèles l'une à l'autre et approximativement perpendiculaires à la ligne droite de liaison des têtes d'électrodes sondes (210, 220).

4. Dispositif de sonde à influence suivant l'une quelconque des revendications précédentes, caractérisé en ce que deux groupes d'électrodes sondes (21, 22) sont prévus, les têtes d'électrodes sondes (210, 220) des deux groupes sont disposées chaque fois sur une ligne droite, et ces lignes droites s'étendant parallèlement l'une à l'autre et à une courte distance l'une de l'autre, et les parties restantes des électrodes sondes (21, 22), s'étendent chaque fois de l'un des côtés opposés l'un à l'autre des lignes droites, les électrodes sondes d'un groupe étant espacées les unes des autres dans le sens de la ligne droite d'une distance au milieu correspondant environ au double de la dimension d'une ouverture (41) dans ce sens et les électrodes sondes des deux groupes sont décalées l'une de l'autre dans ce sens de la dimension d'une ouverture (41).

5. Dispositif de sonde à influence suivant l'une quelconque des revendications précédentes, caractérisé en ce que le substrat (1) présente une surface plane (11) sur laquelle les têtes d'électrodes sondes (210, 220) sont situées et cette surface est bornée par deux faces latérales planes inclinées (12, 13) qui se recoupent suivant une ligne droite située à l'extérieur du substrat.

6. Dispositif de sonde à influence suivant l'une quelconque des revendications 1 à 4, caractérisé en ce que le substrat (1) a la forme d'une lentille cylindrique (formé d'un segment de cylindre) et les têtes d'électrodes sondes (210, 220) sont disposées en une ou deux rangées dans le sens de l'axe du cylindre.

7. Dispositif de sonde à influence suivant l'une quelconque des revendications précédentes, caractérisé en ce que le substrat (1) est en verre au quartz.

8. Dispositif de sonde à influence suivant l'une quelconque des revendications précédentes, caractérisé en ce que la couche isolante (3) est en SiO₂.

9. Procédé pour fabriquer un dispositif de sonde à influence suivant la revendication 1, caractérisé en ce qu'on commence par appliquer sur le substrat (1) une première couche conductrice dans laquelle on forme ensuite les pistes électrodes (21, 22) par morsure, puis on applique sur la première couche conductrice travaillée par morsure une couche isolante (3) sur laquelle on applique ensuite une seconds couche conductrice (4) dans laquelle les ouvertures (41) sont formées par morsure.

10. Procédé pour fabriquer un dispositif de sonde à influence suivant la revendication 1, caractérisé en ce qu'on métallise tout d'abord des deux côtés, une pellicule isolante électrique mince et flexible, on forme par morsure les pistes électrodes d'un côté dans la couche métallique, on forme par morsure les ouvertures (41) délimitant les têtes d'électrodes sondes (210, 220) de l'autre côté et on tend ou on colle la pellicule ainsi traitée sur un substrat isolant électrique (1) de forme adéquate.

FIG.1

FIG.2a

FIG.2b

FIG.2c